# DEMANDE DE BREVET EUROPEEN

(11) **EP 0 886 327 A1**
(43) Date de publication de la demande: **23.12.1998**
(21) Numéro de dépôt: 98401412.6
(22) Date de dépôt: 11.06.1998
(51) Int. Cl.: H01L 39/24

(54) **Procédé de texturation d'un conducteur supraconducteur HTC, conducteur réalisé selon un tel procédé**

(30) Priorité: 12.06.1997 FR 9707283
(71) Demandeur: ALCATEL ALSTHOM COMPAGNIE GENERALE D'ELECTRICITE, 75008 Paris (FR)
(72) Inventeur: Duperray, Gérard, 91290 La Norville (FR); Herrmann, Peter Friedrich, 91410 Corbeuse (FR); Legat, Denis, 91090 Lisses (FR); Leriche, Albert, 91190 Gif sur Yvette (FR); Tavergnier, Jean-Pierre, 91310 Linas (FR)
(74) Mandataire: Feray, Valérie

(57) **Abrégé**

L'invention concerne un conducteur multifilamentaire supraconducteur HTc à matrice à base d'argent (2) et à matériau supraconducteur (3) (Bi₁₋ₓPbₓ)₂Sr₂Ca_{y}Cu_{1+y}O_{6+2y} avec x ∈ [0; 0,4] et y ∈ {0,1,2} texturé présentant un taux de courts-circuits (1) entre filaments (3) inférieur à 1 pour 100µm de conducteur.

## Description

l'invention concerne un procédé de texturation d'un conducteur supraconducteur HTc à matrice à base d'argent et à matériau supraconducteur (Bi₁₋ₓPbₓ)₂Sr₂Ca_{y}Cu_{1+y}O_{6+2y} avec x ∈ [0; 0,4] et y ∈ {0,1,2}, et un tel conducteur texturé selon le procédé. Plus particulièrement l'invention concerne un conducteur supraconducteur multifilamentaire à matrice à base d'argent.

La texturation de conducteur supraconducteur HTc à matrice à base d'argent et à matériau supraconducteur (Bi₁₋ ₓPbₓ)₂Sr₂Ca_{y}Cu_{1+y}O_{6+2y} avec x ∈ [0; 0,4] et y ∈ {0, 1, 2} vers la phase supraconductrice est effectuée par traitement thermique. Typiquement les procédés de texturation comprennent les étapes suivantes :
une montée en température du conducteur entre la température ambiante et la température de fusion du matériau supraconducteur;
un court palier de maintien du conducteur à la température de fusion du matériau supraconducteur;
une descente de température du conducteur entre la température de fusion du matériau supraconducteur et la température de synthèse du matériau supraconducteur la pente de la descente étant de l'ordre de 1 à 5 °C par heure;
un long palier de maintien du conducteur à la température de synthèse du matériau supraconducteur entre 25 et 70 heures;
une descente en température du conducteur entre la température de synthèse du matériau supraconducteur et la température ambiante.

Cette texturation permet d'obtenir, pour des conducteurs multifilamentaires, une capacité de transport de courant très importante.

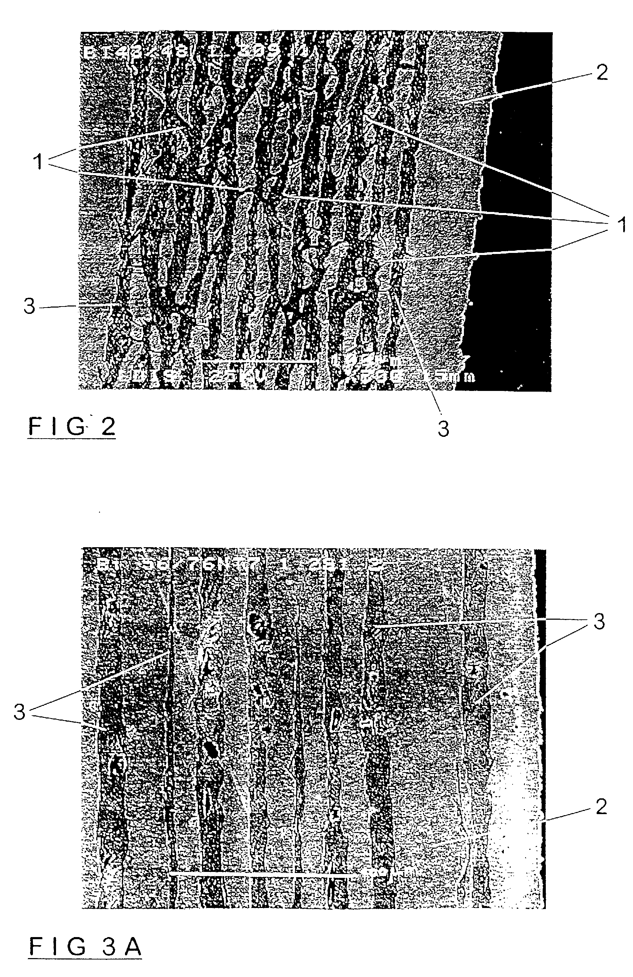

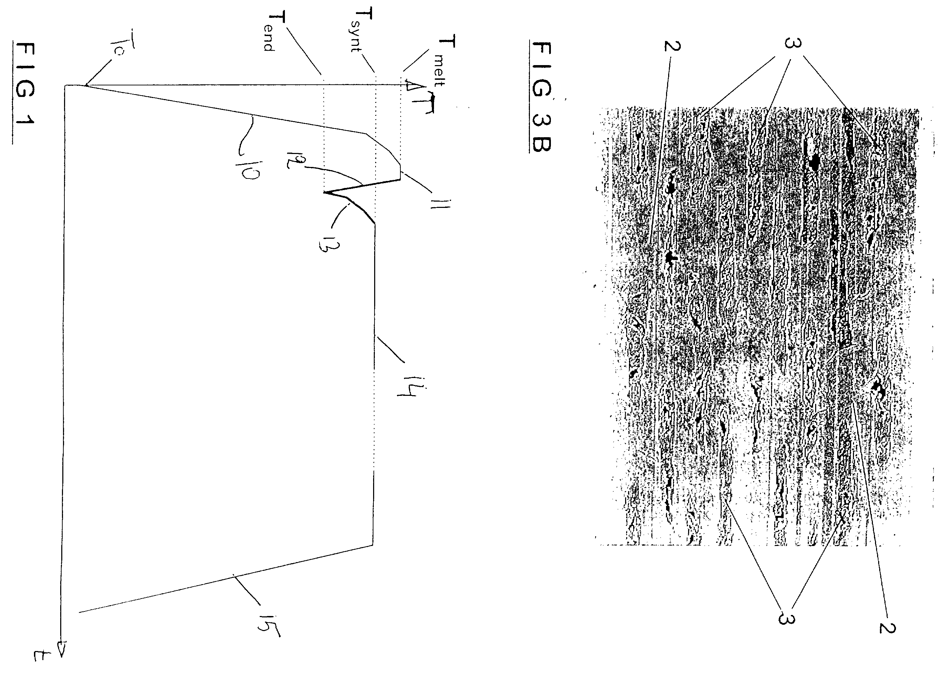

Cependant, la descente de température du conducteur entre la température de fusion du matériau supraconducteur et la température de synthèse du matériau supraconducteur à raison de 1 à 5 °C par heure prend quelques heures. Durant cette descente, les composants constituant le matériau supraconducteur, fondus et très réactifs, forment des inserts dendritiques traversants dans la matrice d'argent. De ce fait, (fig 1) le découplage des filaments 3 entre eux est très mauvais. La présence de nombreux courts-circuits 1 limite l'utilisation de tels conducteurs à des applications en courant continu.

En effet, L'utilisation en courant alternatif des conducteurs supraconducteurs multifilamentaires HTc provoque des pertes par courants induits. Il est connu de réduire ces pertes en torsadant le conducteur avec un pas très petit et en diminuant le diamètre des filaments. Ce moyen n'est cependant efficace que si les filaments sont électriquement découplés les uns des autres par une barrière résistive.

L'un des buts de la présente invention est de proposer un procédé de texturation de conducteurs supraconducteur HTc à matrice à base d'argent et à matériau supraconducteur (Bi₁₋ₓPbₓ)₂Sr₂Ca_{y}Cu_{1+y}O_{6+2y} avec x ∈ [0; 0,4] et y ∈ {0,1,2} vers la phase supraconductrice, qui limite la formation d'inserts traversants.

Un autre but de la présente invention est de proposer un conducteur multifilamentaire supraconducteur HTc à matrice à base d'argent et à matériau supraconducteur (Bi₁₋ₓPbₓ)₂Sr₂Ca_{y}Cu_{1+y}O_{6+2y} avec x ∈ [0; 0,4] et y ∈ {0,1,2} ayant des performances de densité de courant supérieure à 2400 A/mm² et présentant un découplage inter-filament suffisant pour des applications en courant alternatif.

A cet effet l'invention concerne un procédé de texturation d'un conducteur supraconducteur HTc à matrice à base d'argent et à matériau supraconducteur (Bi₁₋ ₓPbₓ)₂Sr₂Ca_{y}Cu_{1+y}O_{6+2y} avec x ∈ [0; 0,4] et y ∈ {0,1,2} comprenant successivement
une montée en température du conducteur entre la température ambiante et la température de fusion du matériau supraconducteur;
un court palier de maintien du conducteur à la température de fusion du matériau supraconducteur;
une étape de variation de température du conducteur entre la température de fusion du matériau supraconducteur et la température de synthèse du matériau supraconducteur;
un long palier de maintien du conducteur à la température de synthèse du matériau supraconducteur;
une descente en température du conducteur entre la température de synthèse du matériau supraconducteur et la température ambiante.

Selon l'invention, l'étape de variation de température du conducteur entre la température de fusion du matériau supraconducteur et la température de synthèse du matériau supraconducteur comprend :
un refroidissement brutal du conducteur entre la température de fusion du matériau supraconducteur et une température de fin de refroidissement, ladite température de fin de refroidissement étant inférieure à la température de synthèse du matériau supraconducteur; et
une montée en température du conducteur entre la température de fin de refroidissement et la température de synthèse du matériau supraconducteur.
le conducteur peut être un conducteur multifilamentaire, réalisé selon un procédé de type "PIT" (Powder In Tube).

Le procédé peut être appliqué à un matériau supraconducteur encore sous forme de précurseurs non-complètement synthétisés.

Le procédé peut aussi être appliqué à un matériau supraconducteur déjà synthétisé en phase supraconducteur.

L'invention concerne aussi un conducteur multifilamentaire supraconducteur HTc à matrice à base d'argent et à matériau supraconducteur (Bi₁₋ₓPbₓ)₂Sr₂Ca_{y}Cu_{1+y} O_{6+2y} avec x ∈ [0; 0,4] et y ∈ {0,1,2} texturé selon le procédé ci-dessus.

Selon l'invention, le conducteur multifilamentaire supraconducteur HTc présente un taux de court-circuit entre filaments inférieur à 1 pour 100µm de conducteur.

Un premier avantage du procédé selon l'invention résulte de la diminution conséquente du nombre d'insert traversant entre filaments.

Un autre avantage de la présente invention résulte de la diminution conséquente du temps de traitement de texturation. En effet, la durée de l'étape de variation de température du conducteur entre la température de fusion du matériau supraconducteur et la température de synthèse du matériau supraconducteur est typiquement de l'ordre d'une vingtaine d'heures (1 à 5°C par heure). Dans le procédé selon la présente invention cette durée est ramenée à deux heures, voire moins.

un troisième avantage du procédé selon la présente invention résulte du fait que ledit procédé ne nécessite aucun matériel supplémentaire par rapport à celui utilisé dans l'art antérieur, seule la programmation du four doit être modifiée.

D'autres avantages et caractéristiques de la présente invention résulteront de la description qui va suivre en référence aux dessins annexés dans lesquels :
la figure 1 montre une courbe de température schématique du procédé de texturation selon l'invention.
La figure 2 montre une vue en coupe longitudinale d'un conducteur multifilamentaire réalisé selon les procédés de l'art antérieur.
Les figures 3A, 3B, montrent respectivement une vue en coupe longitudinale, et une vue en coupe transversale d'un conducteur multifilamentaire selon l'invention.

Dans la description qui va suivre on entend par :
* matériau supraconducteur, un matériau soit déjà en phase supraconductrice, soit sous forme de précurseurs, qui après traitement thermique adéquate seront synthétisé en phase supraconductrice.
* température de fusion du matériau supraconducteur, la température au-delà de laquelle au moins une partie des composants constitutifs du matériau supraconducteur sont en phase liquide.
* température de synthèse du matériau supraconducteur, la température à laquelle se fait la synthèse de la phase supraconductrice du matériau.

Le procédé de texturation d'un conducteur supraconducteur HTc à matrice à base d'argent et à matériau supraconducteur (Bi₁₋ₓPbₓ)₂Sr₂Ca_{y}Cu_{1+y}O_{6+2y} avec x ∈ [0; 0,4] et y ∈ {0,1,2} selon l'invention comprend successivement :
* Une montée en température 10 du conducteur entre la température ambiante T₀ et la température de fusion Tₘₑₗₜ du matériau supraconducteur. Durant cette étape, le matériau, qu'il ait été initialement sous forme synthétisé ou non, n'est pas en Phase supraconductrice.
* Un court palier de maintien 11 du conducteur à la température de fusion Tₘₑₗₜ du matériau supraconducteur. Cette étape a pour but d'obtenir une fusion homogène au sein du matériau.
* Une étape de variation de température 16 du conducteur entre la température de fusion Tₘₑₗₜ du matériau supraconducteur et la température de synthèse T_{synt} du matériau supraconducteur comprenant :
   ** un refroidissement brutal 12 du conducteur entre la température de fusion Tₘₑₗₜ du matériau supraconducteur et une température de fin de refroidissement T_{end}, ladite température de fin de refroidissement T_{end} étant inférieure à la température de synthèse T_{synt} du matériau supraconducteur. Durant cette brutale solidification, après le palier à Tₘₑₗₜ, les composants sont refroidis sous forme de précurseurs cristallisés ou vitreux, ayant une structure granulaire fine.
   ** Une montée contrôlée en température 13 du conducteur entre la température de fin de refroidissement T_{end} et la température de synthèse T_{synt} du matériau supraconducteur. La combinaison des deux sous-étapes précédentes, permet aux grains fins des précurseurs de se synthétiser en phase supraconductrice. L'état semi-solide des composants affleurant la température de synthèse T_{synt} du matériau supraconducteur par valeur inférieure permettant la formation d'un matériau dense et texturé ne présentant quasiment pas d'inserts ou excroissances dendritiques traversants comme dans l'art antérieur.
* Un long palier de maintien 14 du conducteur à la température de synthèse T_{synt} du matériau supraconducteur. Cette étape permet la synthèse complète du matériau.
* Une descente en température 15 du conducteur entre la température de synthèse T_{synt} du matériau supraconducteur et la température ambiante T₀.

Le procédé peut être appliqué à différents stades de la fabrication d'un conducteur multifilamentaire selon la technique powder in tube (PIT).

Il est rappelé que cette technique consiste à remplir une billette de réactifs poudreux susceptibles, après traitement thermique, de se transformer en matériau supraconducteur du type céramique HTc. Le procédé selon la présente invention concerne ledit traitement thermique.

Cette billette est ensuite fermée sous vide et étirée, mise en faisceau dans une nouvelle billette elle-même fermée sous vide et étirée à son tour. Le brin multifilamentaire résultant peut subir les mêmes étapes, et ainsi de suite jusqu'au nombre de filaments par unité de surface voulu.

Le brin ainsi réalisé est alors mis en forme définitive par exemple par laminage et/ou torsadage. Puis traité thermiquement pour la transformation des réactifs poudreux.

Le traitement thermique selon l'invention peut intervenir à différents niveaux de la technique de fabrication powder in tube.

Par exemple plusieurs fois l'issue de l'étape monofilamentaire et d'un certain nombre d'étapes multifilamentaires; ou une seule fois à l'issue de l'étape de mis en forme du conducteur multifilamentaire avant ou après torsadage; etc...

De ce fait on comprend que le matériau supraconducteur subissant le procédé selon l'invention peut-être initialement sous forme de précurseurs non-synthétisés, ou en phase supraconducteur synthétisée, en effet la montée en température 10 jusqu'à Tₘₑₗₜ réinitialise les composants en précurseurs quel que soit leur état initial.

L'invention concerne aussi un conducteur multifilamentaire supraconducteur HTc à matrice à base d'argent 2 et à matériau supraconducteur (Bi₁₋ₓPbₓ)₂Sr₂Ca_{y}Cu_{1+y} O_{6+2y} avec x ∈ [0; 0,4] et y ∈ (0,1,2} texturé selon le procédé de l'invention. Ce conducteur multifilamentaire présente un taux moyen de courts-circuits 1 entre filaments 3 inférieur à 1 pour 100µm de conducteur pour des densités de courant supérieurs à 2400 A/mm². Cela en fait un conducteur utilisable pour les applications alternatives demandant une forte densité de courant en particulier, lorsque le conducteur ainsi réalisé subit une étape de torsadage ultérieure, il présente moins d'un court-circuit entre filament par pas de torsade.

Dans un exemple de réalisation, non limitatif, avec une condition de pression partielle d'oxygène de 3%:
la température de fusion Tₘₑₗₜ est comprise entre 850 et 880 °C.

Le refroidissement brutal 12 a une pente de l'ordre de 240°/heure pour une trentaine de minutes de durée, T_{end} est donc compris entre 730 et 760 °C.

La montée contrôlée en température 13 dure entre 1 h et 1 h 40' pour passer de T_{end} à la température de synthèse T_{synt} comprise entre 770 et 840 °C selon les coefficients des composants du matériau.

Le procédé selon l'invention permet par exemple de fabriquer des conducteurs supraconducteurs multifilamentaires HTc du type Bi2223 ou Bi2212.

Bien entendu, l'invention n'est pas limitée aux modes de réalisation décrits et représentés, mais elle est susceptible de nombreuses variantes accessibles à l'homme du métier sans que l'on s'écarte de l'invention. En particulier, on pourra, sans sortir du cadre de l'invention, modifier la pression partielle d'oxygène ce qui bien entendu influera sur les fourchettes de températures proposées dans l'exemple illustratif de réalisation. La coupe transversale du conducteur selon l'invention peut être différente, par exemple ronde ou hexagonale, sans que l'on s'écarte de l'invention. La disposition des filaments dans le conducteur peut aussi être différente sans que l'on s'écarte de l'invention.

## Revendications

1. Procédé de texturation d'un conducteur supraconducteur HTc à matrice à base d'argent (2) et à matériau supraconducteur (3) (Bi₁₋ₓPbₓ)₂Sr₂Ca_{y}Cu_{1+y}O_{6+2y} avec x ∈ [0; 0,4] et y ∈ {0,1,2} comprenant successivement
une montée en température (10) du conducteur entre la température ambiante et la température de fusion du matériau supraconducteur;
un court palier de maintien (11) du conducteur à la température de fusion du matériau supraconducteur;
une étape de variation de température (16) du conducteur entre la température de fusion du matériau supraconducteur et la température de synthèse du matériau supraconducteur;
un long palier de maintien (14) du conducteur à la température de synthèse du matériau supraconducteur;
une descente en température (15) du conducteur entre la température de synthèse du matériau supraconducteur et la température ambiante
le procédé est caractérisé en ce que l'étape de variation de température (16) du conducteur entre la température de fusion du matériau supraconducteur et la température de synthèse du matériau supraconducteur comprend :
un refroidissement brutal (12) du conducteur entre la température de fusion du matériau supraconducteur et une température de fin de refroidissement, ladite température de fin de refroidissement étant inférieure à la température de synthèse du matériau supraconducteur; et
une montée en température (13) du conducteur entre la température de fin de refroidissement et la température de synthèse du matériau supraconducteur.

2. Procédé selon la revendication 1 caractérisé en ce que le conducteur est un conducteur multifilamentaire.

3. Procédé selon la revendication 1 ou 2 caractérisé en ce que le matériau supraconducteur est initialement sous forme de précurseurs non-synthétisés.

4. Procédé selon la revendication 1 ou 2 caractérisé en ce que le matériau supraconducteur est initialement en phase supraconductrice synthétisée.

5. Conducteur multifilamentaire supraconducteur HTc à matrice à base d'argent (2) et à matériau supraconducteur (3) (Bi₁₋ₓPbₓ)₂Sr₂Ca_{y}Cu_{1+y}O_{6+2y} avec x ∈ [0; 0,4] et y ∈ {0,1,2} texturé par le procédé selon l'une quelconque des revendications 1 à 4 caractérisée en ce qu'il présente un taux de courts-circuits (1) entre filaments (3) inférieur à 1 pour 100µm de conducteur.

6. Conducteur multifilamentaire surpaconducteur selon la revendication 5 caractérisé en ce qu'il est torsadé et comprend moins d'un court-circuit entre filament par pas de torsade.
